# EUROPEAN PATENT APPLICATION

(11) **EP 2 549 544 A1**
(43) Date of publication of application: **23.01.2013**
(21) Application number: 10847959.3
(22) Date of filing: 08.09.2010
(51) Int. Cl.: H01L 31/04

(54) **SOLAR CELL AND METHOD FOR MANUFACTURING SAME**

(30) Priority: 18.03.2010 JP 2010061891
(71) Applicant: Fuji Electric Co., Ltd., Kawasaki-shi Kanagawa 210-9530 (JP)
(72) Inventor: OHSE Naoyuki, Kawasaki-shi Kanagawa 210-9530 (JP); TAKENAKA Kensuke, Kawasaki-shi Kanagawa 210-9530 (JP)
(74) Representative: MERH-IP Matias Erny Reichl Hoffmann
(86) International application number: PCT/JP2010/065400
(87) International publication number: WO 2011/114551

(57) **Abstract**

Provided is a photovoltaic cell with superior cell characteristics, and a method of manufacturing the photovoltaic cell.

A method of manufacturing a photovoltaic cell having at least one or more layers of a photoelectric conversion element in which an i-type silicon layer formed of a microcrystalline silicon film is provided between an n-type silicon layer and a p-type silicon layer, and the n-type silicon layer or p-type silicon layer positioned on a substrate side is configured of an amorphous silicon film, is such that the photovoltaic cell is manufactured by the photoelectric conversion element being formed using a plasma CVD method whereby a mixture of a silane containing gas and hydrogen gas is introduced into a chamber, and a seed layer formed of a microcrystalline silicon film being formed between the n-type silicon layer or p-type silicon layer positioned on the substrate side and the i-type silicon layer, with the crystallization rate of a portion in contact with the n-type silicon layer or p-type silicon layer positioned on the substrate side being lower than that of the i-type silicon layer, and the crystallization rate increasing continuously, or gradually in two or more stages, toward the i-type silicon layer side, continuing to the i-type silicon layer.

## Description

### Technical Field

The present invention relates to a photovoltaic cell having at least one or more layers of a photoelectric conversion element in which an i-type silicon layer formed of a microcrystalline silicon film is provided between an n-type silicon layer and a p-type silicon layer, and to a method of manufacturing the photovoltaic cell.

### Background Art

A photovoltaic cell is a power generating device that converts light energy into electrical power. There are photovoltaic cells that have a structure wherein a transparent electrode is formed on a light permeable insulating substrate of glass, or the like, a photoelectric conversion element wherein a p-type silicon layer, an i-type silicon layer, and an n-type silicon layer are stacked sequentially is formed on the transparent electrode, and furthermore, a metal thin film rear surface electrode is formed on the photoelectric conversion element. Also, as another kind, there are photovoltaic cells that have a structure wherein a rear surface electrode is formed on an insulating plastic film substrate of a polyimide film, or the like, a photoelectric conversion element wherein an n-type silicon layer, an i-type silicon layer, and a p-type silicon layer are stacked sequentially is formed on the rear surface electrode, and furthermore, a transparent electrode is formed on the photoelectric conversion element.

To date, amorphous silicon has been most common as a material configuring the photoelectric conversion elements of these photovoltaic cells. In recent years, microcrystalline silicon has been coming into use. A photoelectric conversion element in which microcrystalline silicon is used (hereafter referred to as a microcrystalline silicon series photoelectric conversion element) is more highly sensitive to long-wavelength light than a photoelectric conversion element in which amorphous silicon is used (hereafter referred to as an amorphous silicon series photoelectric conversion element), and long-wavelength light that cannot be absorbed by an amorphous silicon series photoelectric conversion element can be utilized in generating power. For example, it is known that, by adopting a multi-junction type structure wherein an amorphous silicon series photoelectric conversion element and a microcrystalline silicon series photoelectric conversion element are stacked sequentially from the light incident side, power generating efficiency improves further.

Also, it is known that, by forming the i-type silicon layer with a microcrystalline silicon film and forming the n-type silicon layer and/or p-type silicon layer with an amorphous silicon film in a photovoltaic cell in which a microcrystalline silicon series photoelectric conversion element is used, the collection capability of generated carriers is improved, and cell characteristics improve.

However, although a microcrystalline silicon film and amorphous silicon film can be formed using a CVD method, therefore having superior productivity, it is difficult to form a microcrystalline silicon film on an amorphous silicon film. Because of this, at an initial stage of forming a microcrystalline silicon film on an amorphous silicon film, the microcrystalline silicon film is liable to become amorphous silicon, without microcrystalline silicon being obtained. As a result of this, there is a problem in that the film quality at the interface between the microcrystalline silicon film and amorphous silicon film worsens, and cell characteristics are liable to be lost.

In Patent Document 1, it is disclosed that, after forming a seed layer using a raw material gas with a lower concentration of silane containing gas than in a raw material gas for forming an i-type silicon layer on a p-type silicon layer, the i-type silicon layer formed of a microcrystalline silicon film is formed on the seed layer, in order to improve the film quality at the junction interface when forming an i-type silicon layer formed of a microcrystalline silicon film on a p-type silicon layer.

### Related Art Documents

### Patent Documents

Patent Document 1: JP-T-2009-542008 (refer to paragraph number 0036)

### Outline of the Invention

### Problems to be Solved by the Invention

However, with the photovoltaic cell obtained using the method disclosed in Patent Document 1, the improvement in cell characteristics was insufficient.

Consequently, an object of the invention is to provide a photovoltaic cell with superior cell characteristics, and a method of manufacturing the photovoltaic cell.

### Means for Solving the Problems

In order to achieve the heretofore described object, a photovoltaic cell of the invention is a photovoltaic cell having at least one or more layers of a photoelectric conversion element in which an i-type silicon layer formed of a microcrystalline silicon film is provided between an n-type silicon layer and a p-type silicon layer,
characterized in that the photoelectric conversion element is such that the n-type silicon layer or p-type silicon layer positioned on a substrate side is configured of an amorphous silicon film,
and a seed layer formed of a microcrystalline silicon film is provided between the n-type silicon layer or p-type silicon layer positioned on the substrate side and the i-type silicon layer, with the crystallization rate of a portion in contact with the n-type silicon layer or p-type silicon layer positioned on the substrate side being lower than that of the i-type silicon layer, and the crystallization rate increasing continuously, or gradually in two or more stages, toward the i-type silicon layer side, continuing to the i-type silicon layer.

It is preferable that the seed layer is configured of two or more layers of microcrystalline silicon film with differing crystallization rates.

It is preferable that, when the i-type silicon layer and seed layer are each formed on the same substrate, the seed layer is formed under film forming conditions such that films of microcrystalline silicon with a crystallization rate higher than that of the i-type silicon layer can be formed.

Also, a photovoltaic cell manufacturing method of the inventions is a method of manufacturing a photovoltaic cell having at least one or more layers of a photoelectric conversion element in which an i-type silicon layer formed of a microcrystalline silicon film is provided between an n-type silicon layer and a p-type silicon layer, and the n-type silicon layer or p-type silicon layer positioned on a substrate side is configured of an amorphous silicon film,
the method being characterized in that the photoelectric conversion element is formed using a plasma CVD method whereby a mixture of a silane containing gas and hydrogen gas is introduced into a chamber,
and a seed layer formed of a microcrystalline silicon film is formed between the n-type silicon layer or p-type silicon layer positioned on the substrate side and the i-type silicon layer, with the crystallization rate of a portion in contact with the n-type silicon layer or p-type silicon layer positioned on the substrate side being lower than that of the i-type silicon layer, and the crystallization rate increasing continuously, or gradually in two or more stages, toward the i-type silicon layer side, continuing to the i-type silicon layer.

It is preferable that formation of the seed layer is started under a condition such that the concentration of silane containing gas in the mixture is lower than that when forming the i-type silicon layer, in a condition in which the pressure inside the chamber, the applied power, and the inter-electrode distance are constant, and the concentration of silane containing gas in the mixture is increased continuously, or gradually in two or more stages, eventually being increased as far as the concentration of silane containing gas when forming the i-type silicon layer.

### Advantage of the Invention

According to the invention, by providing a seed layer formed of a microcrystalline silicon film between the n-type silicon layer or p-type silicon layer positioned on the substrate side and the i-type silicon layer formed from a microcrystalline silicon film, with the crystallization rate of a portion in contact with the n-type silicon layer or p-type silicon layer positioned on the substrate side being lower than that of the i-type silicon layer, and the crystallization rate increasing continuously, or gradually in two or more stages, toward the i-type silicon layer side, continuing to the i-type silicon layer, formability of the microcrystalline silicon film is improved, and it is possible to form an i-type silicon layer formed of a microcrystalline silicon film of good quality.

Because of this, the electrical junctions between the p-type silicon layer and n-type silicon layer and the i-type silicon layer are good, and it is thus possible to further improve the cell characteristics of the photovoltaic cell.

### Brief Description of the Drawings

[Fig. 1] Fig. 1 is a schematic view of a photovoltaic cell of the invention.
[Fig. 2] Fig. 2 is a schematic view of a plasma CVD device used in manufacturing the photovoltaic cell of the invention. Mode for Carrying Out the Invention

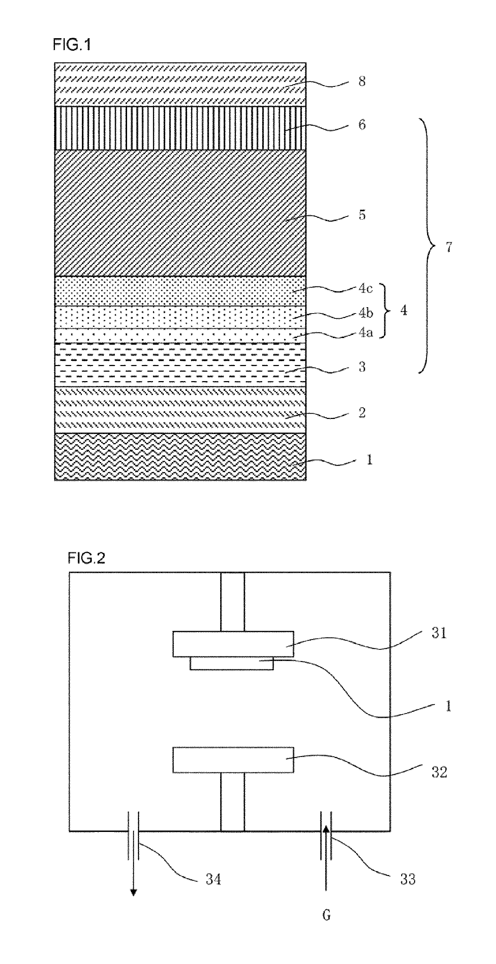

A description will be given of a photovoltaic cell of the invention, with a photovoltaic cell shown in Fig. 1 as an example.

In the photovoltaic cell shown in Fig. 1, a rear surface electrode 2 is formed on a substrate 1, and an n-i-p-type photoelectric conversion element 7, wherein an n-type silicon layer 3, a seed layer 4, an i-type silicon layer 5, and a p-type silicon layer 6 are stacked sequentially, is formed on the rear surface electrode 2. Then, a transparent electrode 8 is formed on the surface of the photoelectric conversion element 7.

There is no particular restriction on the substrate 1. For example, it is possible to use an insulating plastic film substrate such as a polyimide film, a polyethylene terephthalate film, a polyethylene naphthalate film, a polyethersulfone film, an acrylic film, or an aramid film, a glass substrate, or a stainless steel substrate. When the substrate 1 is disposed on the light incident side, it goes without saying that the substrate 1 should be configured of a light permeable material.

There being no particular restriction on the material configuring the rear surface electrode 2, metals such as Ag, Al, or Ti, or alloys thereof, are included.

The n-type silicon layer 3 is configured of an amorphous silicon thin film. By the n-type silicon layer 3 being configured of an amorphous silicon thin film, reverse diffusion current decreases, the collection capability of generated carriers is improved, and cell characteristics improve.

The thickness of the n-type silicon layer 3 is preferably 5 to 60nm, and more preferably 20 to 40nm. When the thickness is less than 5nm, it may happen that the internal electrical field is insufficient. When the thickness exceeds 60nm, it may happen that the absorption of light in the n-type silicon layer has a large effect on the characteristics.

The seed layer 4 is configured by a plurality of layers (three layers in this embodiment) of microcrystalline silicon film being stacked.

As the underlying n-type silicon layer 3 is of amorphous silicon, the crystallization rate of a microcrystalline silicon film 4a disposed in contact with the n-type silicon layer 3, being affected by the n-type silicon layer 3, is lower than the crystallization rate of the i-type silicon layer 5. Then, the crystallization rate increases in the order of microcrystalline silicon films 4a, 4b, and 4c. That is, the crystallization rate of the microcrystalline silicon films configuring the seed layer 4 increases gradually from the n-type silicon layer 3 side toward the i-type silicon layer 5 side, eventually continuing to the i-type silicon layer 5.

In this embodiment, the seed layer 4 is configured of three layers of microcrystalline silicon film with differing crystallization rates, but it is sufficient that there are two or more layers. By the seed layer 4 being configured of two or more layers of microcrystalline silicon film with differing crystallization rates, the film quality of the i-type silicon layer 5 formed on the seed layer 4 improves, and the electrical junction between the n-type silicon layer 3 and i-type silicon layer 5 improves. Also, the same advantage is obtained even when there is only one layer of microcrystalline silicon film configuring the seed layer 4, provided that the microcrystalline silicon film has a gradient such that the crystallization rate is continuously increased from the n-type silicon layer 3 side toward the i-type silicon layer 5 side. The crystallization rate of a microcrystalline silicon film in the invention means a ratio (h⁵²⁰/h⁴⁸⁰) between a peak height of 520cm⁻¹ (h⁵²⁰) and a peak height of 480cm⁻¹ (h⁴⁸⁰), obtained when measuring, using Raman scattering spectroscopy, a sample film formed to in the region of a few tens of nanometers on an n-type silicon layer formed from an amorphous silicon film.

It is preferable that the seed layer 4 is configured of microcrystalline silicon films more microcrystalline than the i-type silicon layer 5, and more preferable that the grain diameter of the microcrystalline silicon gradually increases from the n-type silicon layer 3 side toward the i-type silicon layer 5 side, eventually continuing to the i-type silicon layer 5.

When the i-type silicon layer 5 and seed layer 4 are each formed on the same substrate, it is preferable that the seed layer 4 is formed under film forming conditions such that films of microcrystalline silicon with a crystallization rate higher than that of the i-type silicon layer 5 can be formed.

As the underlayer of the i-type silicon layer 5 is the seed layer 4 configured of microcrystalline silicon thin films, the underlayer of the i-type silicon layer 5 is liable to become microcrystalline silicon. Meanwhile, as the underlayer of the seed layer 4 is the n-type silicon layer 3 configured of an amorphous silicon thin film, the underlayer of the seed layer 4, being affected by the underlying silicon layer 3, is liable to become amorphous silicon. Because of this, by the seed layer 4 being formed under film forming conditions such that films of microcrystalline silicon with a crystallization rate higher than that of the i-type silicon layer 5 can be formed, it is possible to form the sheet layer 4 formed of microcrystalline silicon thin films on the n-type silicon layer 3. Furthermore, the seed layer can be formed of thinner films, and the electrical junction between the n-type silicon layer 3 and i-type silicon layer 5 can be improved.

It is preferable that the thickness of the seed layer 4 is 10 to 120nm.

The i-type silicon layer 5 is configured of a microcrystalline silicon film with an impurity concentration of 1 × 10¹⁹ atoms/cm³ or less. Provided that the impurity concentration of the i-type silicon layer 5 is 1 × 10¹⁹ atoms/cm³ or less, electron or hole carrier mobility is good.

It is preferable that the thickness of the i-type silicon layer 5 is 1000 to 2500nm.

The material configuring the p-type silicon layer 6, being configured of an amorphous silicon thin film or microcrystalline silicon film including a p-type impurity such as boron, is preferably an amorphous silicon thin film. By the p-type silicon layer 6 being configured of an amorphous silicon thin film, the cell characteristics improve.

The thickness of the p-type silicon layer 6 is preferably 5 to 20nm, and more preferably 5 to 15nm. When the thickness is less than 5nm, it may happen that the internal electrical field is insufficient, while it is not desirable that the thickness exceeds 20nm, as the absorption of light in the p-type silicon layer has a large effect on the characteristics.

The transparent electrode 8 is configured of a transparent conductive oxide such as ITO (indium oxide + tin oxide), ZnO, TiO₂, SnO₂, or IZO (indium oxide + zinc oxide).

Next, a description will be given of a method of manufacturing the photovoltaic cell of the invention.

Firstly, a film of a metal such as Ag, Al, or Ti, or an alloy thereof, is formed on the substrate 1 using a heretofore known method such as a sputtering method, a vacuum deposition method, a spray film forming method, a screen printing method, an inkjet printing method, or a plating method, thereby forming the rear surface electrode 2.

Next, the substrate on which the rear surface electrode 2 has been formed in this way is introduced into a plasma CVD device, a raw material gas including a silane containing gas and hydrogen gas is introduced into the device, and the formation of each semiconductor layer configuring the photoelectric conversion element is carried out using a plasma CVD method. Any gas formed of an oxide including silane atoms is sufficient as the silane containing gas used in the raw material gas. For example, monosilane (SiH₄), disilane (Si₂H₆), silicon tetrafluoride (SiF₄), silicon tetrachloride (SiCl₄), dichlorosilane (SiH₂Cl₂), and the like, are included as examples.

Fig. 2 shows a schematic view representing one example of a plasma CVD device that can be used in the method of manufacturing the photovoltaic cell of the invention. In the plasma CVD device, a cathode electrode 32 and an anode electrode 31, which are two parallel plate electrodes, are installed opposing each other across a gap (inter-electrode distance). The anode electrode 31 has a heating mechanism (not shown) for heating the substrate 1, while a high frequency power source (not shown) is connected to the cathode electrode 32 via a capacitor. Then, the plasma CVD device is configured so that a raw material gas G is supplied in a shower form through a raw material gas inlet 33 from the cathode electrode 32 side toward the substrate 1, with the flow rate of the raw material gas G controlled by a mass flow controller (not shown), and gas after a reaction is emitted from the chamber through a reaction gas outlet 34.

Using this kind of plasma CVD device, the n-i-p-type photoelectric conversion element 7 is formed by stacking in the order of the n-type silicon layer 3, seed layer 4, i-type silicon layer 5, and p-type silicon layer 6.

That is, firstly, the substrate on which the rear surface electrode 2 has been formed is introduced into the plasma CVD device in which the n-type silicon layer is to be formed. Next, after adjusting the pressure inside the device, the substrate temperature, the applied voltage, and the inter-electrode distance to predetermined values, the raw material gas is introduced at a predetermined flow rate into the plasma CVD device from the raw material gas inlet 33, generating raw material gas plasma, and thereby forming an amorphous silicon film configuring the n-type silicon layer 3 on the rear surface electrode 2. The n-type silicon layer 3 can be formed under heretofore known film forming conditions.

After forming the n-type silicon layer 3 on the rear surface electrode 2 in this way, formation of the seed layer 4 and i-type silicon layer 5 is carried out, but in the case of the invention, the seed layer 4 and i-type silicon layer 5 are formed consecutively in one plasma CVD device. Firstly, after adjusting the pressure inside the plasma CVD device, the substrate temperature, the applied voltage, and the inter-electrode distance to predetermined values, and in a condition in which these values are constant, film formation is started under a condition such that the concentration of silane containing gas in the raw material gas is lower than that in the raw material gas used in forming the i-type silicon layer 5. That is, when the i-type silicon layer 5 and seed layer 4 are each formed on the same substrate, the seed layer 4 is formed under film forming conditions such that films of microcrystalline silicon with a crystallization rate higher than that of the i-type silicon layer 5 can be formed. Then, with no break, the i-type silicon layer 5 is formed by the concentration of silane containing gas in the raw material gas being increased continuously, or gradually in two or more stages, eventually being increased as far as the concentration of silane containing gas when forming the i-type silicon layer. Specifically, formation of the microcrystalline silicon film configuring the seed layer 4 is started using a raw material gas including silane gas and hydrogen gas in a proportion of 1:400 to 800 by flow ratio, and, with no break, the formation of the i-type silicon layer 5 is carried out by the concentration of silane containing gas in the raw material gas being increased continuously, or gradually in two or more stages, eventually being adjusted so that a proportion of silane gas to hydrogen gas is 1:100 to 200 by flow ratio. When gradually changing the concentration of silane containing gas in the raw material gas, it is preferable that there are three or more steps.

To describe using a specific example, the microcrystalline silicon film 4a is formed using a raw material gas including silane gas and hydrogen gas in a proportion of 1:400 to 800 by flow ratio, the microcrystalline silicon film 4b is formed using a raw material gas including silane gas and hydrogen gas in a proportion of 1:200 to 400 by flow ratio, the microcrystalline silicon film 4c is formed using a raw material gas including silane gas and hydrogen gas in a proportion of 1:100 to 200 by flow ratio, and the microcrystalline silicon film configuring the i-type silicon layer 5 is formed using a raw material gas including silane gas and hydrogen gas in a proportion of 1:50 to 100 by flow ratio.

As formation of the microcrystalline silicon films is carried out under conditions such that microcrystalline silicon is easily generated by the microcrystalline silicon film formation being started under a condition such that the concentration of silane containing gas in the raw material gas is lower than that when forming the i-type silicon layer 5, in a condition in which the pressure inside the device, the applied power, and the inter-electrode distance are constant, microcrystalline silicon with a small average grain diameter is liable to be generated, but amorphous silicon is unlikely to be generated at the initial film formation stage, despite being on the amorphous silicon film, and it is thus possible to form the microcrystalline silicon films from directly above the amorphous silicon film. Then, by forming the seed layer 4 by continuously or gradually increasing the concentration of silane containing gas in the raw material gas, the crystallization rate increases gradually or continuously toward the i-type silicon layer 5 side, eventually continuing to the microcrystalline silicon film configuring the i-type silicon layer 5, meaning that the film quality in the junction interface is good, and furthermore, the quality of the microcrystalline silicon film configuring the i-type silicon layer 6 is good.

The substrate on which the seed layer 4 and i-type silicon layer 5 have been formed in this way is introduced into the plasma CVD device in which the p-type silicon layer 6 is to be formed. Then, after adjusting the pressure inside the device, the substrate temperature, the applied voltage, and the inter-electrode distance to predetermined values, the raw material gas is introduced at a predetermined flow rate into the plasma CVD device from the raw material gas inlet 33, generating raw material gas plasma, and thereby forming the p-type silicon layer 6. The p-type silicon layer 6 can be formed under heretofore known film forming conditions.

Then, by forming a film of a transparent conductive oxide such as ITO (indium oxide + tin oxide), ZnO, TiO₂, SnO₂, or IZO (indium oxide + zinc oxide) on the p-type silicon layer 6 using a heretofore known method such as a sputtering method, a vacuum deposition method, a spray film forming method, a screen printing method, an inkjet printing method, or a plating method, thereby forming the transparent electrode 8, it is possible to manufacture the photovoltaic cell of the invention.

As the photovoltaic cell of the invention obtained in this way is such that the seed layer 4, formed of microcrystalline silicon films of good quality, is formed on the n-type silicon layer 3, formed of an amorphous silicon film, and furthermore, the i-type silicon layer 5 is formed on the seed layer 4, the electrical junction between the n-type silicon layer 3 and i-type silicon layer 5 is good, and the cell characteristics are superior.

In the embodiment, the formation of the n-type silicon layer 3, the formation of the seed layer 4 and i-type silicon layer 5, and the formation of the p-type silicon layer 6 are each carried out by introduction into individual plasma CVD devices, but they may also be carried out in the same plasma CVD device by using a raw material gas specific to each semiconductor thin film as the raw material gas supplied to the inside of the device. However, when carrying out the formation of each layer using the same plasma CVD device, the film quality decreases, and cleaning of the inside of the device is necessary, due to contamination, or the like, of the raw material gas occurring, meaning that productivity may be lost.

Also, the photovoltaic cell of this embodiment is formed including an n-i-p-type photoelectric conversion element wherein a seed layer, an i-type silicon layer, and a p-type silicon layer are stacked sequentially on an n-type silicon layer formed of an amorphous silicon film, but the photovoltaic cell may also be formed including a p-i-n-type photoelectric conversion element wherein a seed layer, an i-type silicon layer, and an n-type silicon layer are stacked sequentially on a p-type silicon layer formed of an amorphous silicon film.

Also, the photovoltaic cell of this embodiment forms a single layer structure including one layer of photoelectric conversion element, but the photovoltaic cell may also be a multi-junction type structure wherein two or more layers are stacked.

### Working Example

### (Working Example 1)

The substrate 1 on which is formed the rear surface electrode 2, formed of an Ag/ZnO electrode film, is introduced into a capacitively coupled plasma CVD device and, adopting a film forming pressure of 0.6 Torr, a substrate temperature of 300°C, a high frequency power source frequency of 13.56 MHz, and an applied power of 5W, an amorphous silicon film is formed to 30nm by supplying, as a raw material gas, SiH₄ at a flow rate of 6sccm and PH₃ gas at a flow rate of 60sccm, thereby forming the n-type silicon layer 3. The flow rate unit sccm stands for standard cc/min (the flow rate in cm³/min converted to a standard condition).

Next, adopting a film forming pressure of 12 Torr, a substrate temperature of 180°C, a high frequency power source frequency of 40.56 MHz, and an applied power of 200W, the microcrystalline silicon film 4a is formed to 10nm by supplying, as a raw material gas, SiH₄ at a flow rate of 3sccm and H₂ at a flow rate of 1700sccm. Next, the microcrystalline silicon film 4b is formed to 20nm under the same conditions as for the formation of the microcrystalline silicon film 4a, except that only the SiH₄ supply flow rate is changed to 6sccm. Next, the microcrystalline silicon film 4c is formed to 40nm under the same conditions as for the formation of the microcrystalline silicon film 4a, except that only the SiH₄ supply flow rate is changed to 12.5sccm. In this way, the seed layer 4 in which are stacked the microcrystalline silicon films 4a, 4b, and 4c is formed. Then, a microcrystalline silicon film is formed to 200nm under the same conditions as for the formation of the microcrystalline silicon film 4a, except that only the SiH₄ supply flow rate is changed to 25sccm, thereby forming the i-type silicon layer 5.

Next, adopting a film forming pressure of 0.9 Torr, a substrate temperature of 160°C, a high frequency power source frequency of 13.56 MHz, and an applied power of 5W, a microcrystalline silicon film is formed to 20nm by supplying, as a raw material gas, SiH₄ at a flow rate of 5sccm, H₂ at a flow rate of 400sccm, and diborane gas at a flow rate of 55sccm, thereby forming the p-type silicon layer 6.

Then, the photovoltaic cell is manufactured by sequentially forming an ITO transparent electrode film and an Ag pectinate electrode.

### (Comparison Example 1)

In Working Example 1, adopting a film forming pressure of 0.6 Torr, a substrate temperature of 180°C, a high frequency power source frequency of 13.56 MHz, and an applied power of 40W, a microcrystalline silicon film is formed to 30nm by supplying, as a raw material gas, SiH₄ at a flow rate of 4sccm, H₂ at a flow rate of 500sccm, and phosphine gas at a flow rate of 55sccm, thereby forming the n-type silicon layer 3.

Next, adopting a film forming pressure of 12 Torr, a substrate temperature of 180°C, a high frequency power source frequency of 40.56 MHz, and an applied power of 200W, a microcrystalline silicon film is formed to 200nm by supplying, as a raw material gas, SiH₄ at a flow rate of 25sccm and H₂ at a flow rate of 1700sccm, thereby forming the i-type silicon layer 5.

Then, thereafter, the photovoltaic cell of Comparison Example 1 is manufactured in the same way as in Working Example 1.

### (Comparison Example 2)

In Working Example 1, the photovoltaic cell is manufactured in the same way as in Working Example 1, except that the i-type silicon layer 5 is formed directly on the n-type silicon layer 3, without providing the seed layer 4.

### (Comparison Example 3)

In Working Example 1, the photovoltaic cell is manufactured in the same way as in Working Example 1, except that adopting a film forming pressure of 12 Torr, a substrate temperature of 180°C, a high frequency power source frequency of 40.56 MHz, and an applied power of 200W, a microcrystalline silicon film is formed to 50nm by supplying, as a raw material gas, SiH₄ at a flow rate of 5sccm and H₂ at a flow rate of 1700sccm, thereby forming the seed layer 4.

The open circuit voltage (Voc), short circuit current (Jsc), fill factor (FF), and conversion efficiency (Eff) of Working Example 1 and Comparison Examples 1 to 3 are obtained. The results are shown collected in Table 1.

**[Table 1]**

| | n Layer | Seed Layer | i Layer | p Layer | Voc | Jsc | FF | Eff |
|---|---|---|---|---|---|---|---|---|
| Working Example 1 | Amorphous silicon film | Three steps | Microcrystalline silicon film | Microcrystalline silicon film | 1 | 1.05 | 1.01 | 1.06 |
| Comparison Example 1 | Microcrystalline silicon film | None | Microcrystalline silicon film | Microcrystalline silicon film | 1 | 1 | 1 | 1 |
| Comparison Example 2 | Amorphous silicon film | None | Microcrystalline silicon film | Microcrystalline silicon film | 0.95 | 0.95 | 0.82 | 0.71 |
| Comparison Example 3 | Amorphous silicon film | One step | Microcrystalline silicon film | Microcrystalline silicon film | 0.98 | 1.07 | 0.96 | 1.01 |

As seen from the above results, the photovoltaic cell of Working Example 1, wherein two or more layers of the seed layer 4 are provided, has the highest conversion efficiency and superior cell characteristics.

### Description of Reference Numerals and Signs

1: Substrate
2: Rear surface electrode
3: n-type silicon layer
4: Seed layer
5: i-type silicon layer
6: p-type silicon layer
7: Photoelectric conversion element
8: Transparent electrode

## Claims

1. A photovoltaic cell having at least one or more layers of a photoelectric conversion element in which an i-type silicon layer formed of a microcrystalline silicon film is provided between an n-type silicon layer and a p-type silicon layer, the photovoltaic cell being **characterized in that**
the photoelectric conversion element is such that the n-type silicon layer or p-type silicon layer positioned on a substrate side is configured of an amorphous silicon film, and
a seed layer formed of a microcrystalline silicon film is provided between the n-type silicon layer or p-type silicon layer positioned on the substrate side and the i-type silicon layer, with the crystallization rate of a portion in contact with the n-type silicon layer or p-type silicon layer positioned on the substrate side being lower than that of the i-type silicon layer, and the crystallization rate increasing continuously, or gradually in two or more stages, toward the i-type silicon layer side, continuing to the i-type silicon layer.

2. The photovoltaic cell according to claim 1, wherein the seed layer is configured of two or more layers of microcrystalline silicon film with differing crystallization rates.

3. The photovoltaic cell according to claim 1 or 2, wherein, when the i-type silicon layer and seed layer are each formed on the same substrate, the seed layer is formed under film forming conditions such that films of microcrystalline silicon with a crystallization rate higher than that of the i-type silicon layer can be formed.

4. A method of manufacturing a photovoltaic cell having at least one or more layers of a photoelectric conversion element in which an i-type silicon layer formed of a microcrystalline silicon film is provided between an n-type silicon layer and a p-type silicon layer, and the n-type silicon layer or p-type silicon layer positioned on a substrate side is configured of an amorphous silicon film, the method being **characterized in that**
the photoelectric conversion element is formed using a plasma CVD method whereby a mixture of a silane containing gas and hydrogen gas is introduced into a chamber, and
a seed layer formed of a microcrystalline silicon film is formed between the n-type silicon layer or p-type silicon layer positioned on the substrate side and the i-type silicon layer, with the crystallization rate of a portion in contact with the n-type silicon layer or p-type silicon layer positioned on the substrate side being lower than that of the i-type silicon layer, and the crystallization rate increasing continuously, or gradually in two or more stages, toward the i-type silicon layer side, continuing to the i-type silicon layer.

5. The photovoltaic cell manufacturing method according to claim 4, wherein formation of the seed layer is started under a condition such that the concentration of silane containing gas in the mixture is lower than that when forming the i-type silicon layer, in a condition in which the pressure inside the chamber, the applied power, and the inter-electrode distance are constant, and the concentration of silane containing gas in the mixture is increased continuously, or gradually in two or more stages, eventually being increased as far as the concentration of silane containing gas when forming the i-type silicon layer.
